# EUROPEAN PATENT APPLICATION

(11) **EP 2 107 612 A2**
(43) Date of publication of application: **07.10.2009**
(21) Application number: 09150483.7
(22) Date of filing: 13.01.2009
(51) Int. Cl.: H01L 29/786

(54) **Single event transient hardened majority carrier field effect transistor fabricated in an SOI CMOS process**

(30) Priority: 13.03.2008 US 36355 P; 12.01.2009 US 352349
(71) Applicant: Honeywell International Inc., Morristown, NJ 07962 (US)
(72) Inventor: Seefeldt, James, Morristown, NJ 07962-2245 (US); Golke, Keith, Morristown, NJ 07962-2245 (US)
(74) Representative: Buckley, Guy Julian

(57) **Abstract**

Described herein is a majority carrier device. Specifically, an exemplary device may comprise source, channel, and drain regions in a thin semiconductor layer, and the source, channel, and drain region may all share a single doping type of varying concentrations. Further, the device may comprise an insulating layer above the channel region and a gate region above the insulating layer, such that the gate modulates the channel. The device described herein may eliminate the parasitic bipolar transistor and the sensitivity to excess minority carrier generation that results from single event effects (SEE) such as heavy ion hits.

## Description

### STATEMENT REGARDING FEDERALLY SPONSORED RESEARCH

The U.S. government may have certain rights in this invention pursuant to government contract number NRO000-07-C-0034.

### RELATED APPLICATION

This application claims priority to U.S. Provisional Application No. 61/036,355, "Single Event Transient Hardened Majority Carrier Field Effect Transistor Fabricated in an SOI CMOS Process," filed March 13, 2008, the entirety of which is incorporated by reference herein.

### FIELD OF THE INVENTION

The present invention is related to field effect transistors, and related more particularly to majority carrier field effect transistors fabricated using silicon-on-insulator (SOI) complimentary metal-oxide-semiconductor (CMOS) processes.

### BACKGROUND OF THE INVENTION

As the size of metal-oxide-semiconductor (MOS) transistors continue to shrink and the current levels in the circuits designed with these devices is reduced, these circuits become more susceptible to Single Event Effects (SEEs) from ionizing radiation, such as high energy heavy ion hits, high energy protons or neutrons, or x-ray or gamma ray pulses.

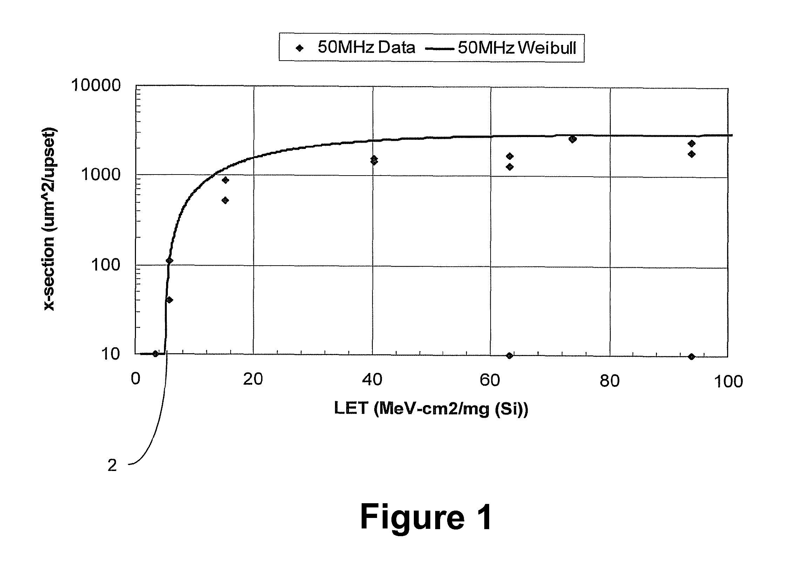

To illustrate, Figure 1 depicts a graph showing the relationship between the multiple SEE sensitive areas of devices in a circuit (y-axis) and the magnitude of linear energy transfer (LET) at which an error is produced in a conventional MOS field effect transistor (FET) technology. As shown, analog and mixed signal circuits designed using fine line CMOS technologies, which operate with current levels in the microampere range and have sensitive areas that are susceptible, around a data point 2, to ionizing radiation hits with a LET as low a 5 MeV-cm2/mg (Si). This is primarily due to the parasitic bipolar transistor present in a standard CMOS device. The parasitic bipolar transistor can be turned on by hits on the channel of the device, which is also the base of the parasitic bipolar transistor.

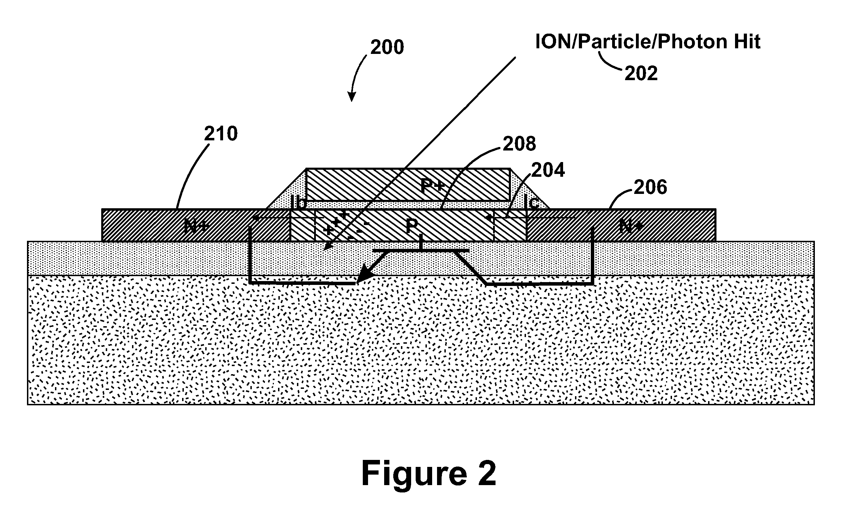

Figure 2 is a diagram showing the event of an ion particle or photon strike 202 on a typical SOI MOS device 200. In particular, strike 202 generates current 204 that activates a parasitic bipolar device made up of source 206, channel 208, and drain 210. The gain of the parasitic bipolar device enhances the current 204 because that gain amplifies the excess of minority carriers inherent in caused by strike 202. In light of the above discussion, a typical MOSFET device is problematic, when used in an environment in which SEEs are likely, due to the existence of parasitic bipolar transistor and its sensitivity to excess minority carrier generation resulting from SEE hits.

### SUMMARY

According to one embodiment of the invention, a field effect transistor may comprise a source region of a first doping type embedded in a thin semiconductor layer, a drain region of the first doping type embedded in the thin semiconductor layer, and a channel region of the first doping type embedded in the thin semiconductor layer. The channel region may be disposed so that a first end of the channel region contacts the source region and a second end of the channel region contacts the drain region. The device may further comprise an insulating layer disposed above the channel region and a gate region disposed above the insulating layer, wherein applying electrical potential to the gate region controls the flow of charge in the channel region.

According to another embodiment of the invention, a majority carrier device may comprise a silicon-on-insulator thin semiconductor layer and a continuous, elongated region of a first doping type embedded at a surface of the thin semiconductor layer. Further, a source contact may comprise one end of the region, and a drain contact may comprise an opposite end of the region. A channel may join the source contact and the drain contact. An insulator may be disposed above the channel, and a gate may be disposed above the insulator, such that the gate may modulate the channel.

According to yet another embodiment of the invention, a majority carrier field effect transistor may comprise a source region, having a dopant concentration of n-type doping, embedded in a thin semiconductor layer; a drain region, having a dopant concentration of n-type doping, embedded in the thin semiconductor layer; and a channel region, having a dopant concentration of n-type doping, embedded in the thin semiconductor layer. The channel region may be disposed so that a first end of the channel region contacts the source region and a second end of the channel region contacts the drain region. Further, the dopant concentration of the channel region may be less than the doping concentration of the source region and the dopant concentration of the drain region. An insulating layer may be disposed above the channel region, and a polysilicon gate region may be disposed above the insulating layer. A second insulating layer of buried oxide may be disposed beneath the thin semiconductor layer. Applying electrical potential to the gate region may cause charge to flow in the channel region.

These as well as other features and advantages will become apparent to those of ordinary skill in the art by reading the following detailed description, with appropriate reference to the accompanying drawings.

### BRIEF DESCRIPTION OF THE DRAWINGS

Figure 1 depicts a graph showing the relationship between the size of a device (y-axis) and the magnitude of linear energy transfer (LET) at which an error is produced in a conventional MOS field effect transistor (FET).
Figure 2 is a diagram showing the event of an ion particle or photon strike on a typical SOI MOS device.
Figure 3a is a diagram showing an n-type majority carrier field effect transistor fabricated with an SOI CMOS process, according to an embodiment of the present invention.
Figure 3b is a diagram showing the effect of a particle strike on an embodiment of the present invention.
Figure 4 is a diagram showing a p-type majority carrier field effect transistor fabricated with an SOI CMOS process, according to another embodiment of the present invention.
Figure 5 depicts a graph showing the high frequency capabilities of yet another embodiment of the present invention.

### DETAILED DESCRIPTION

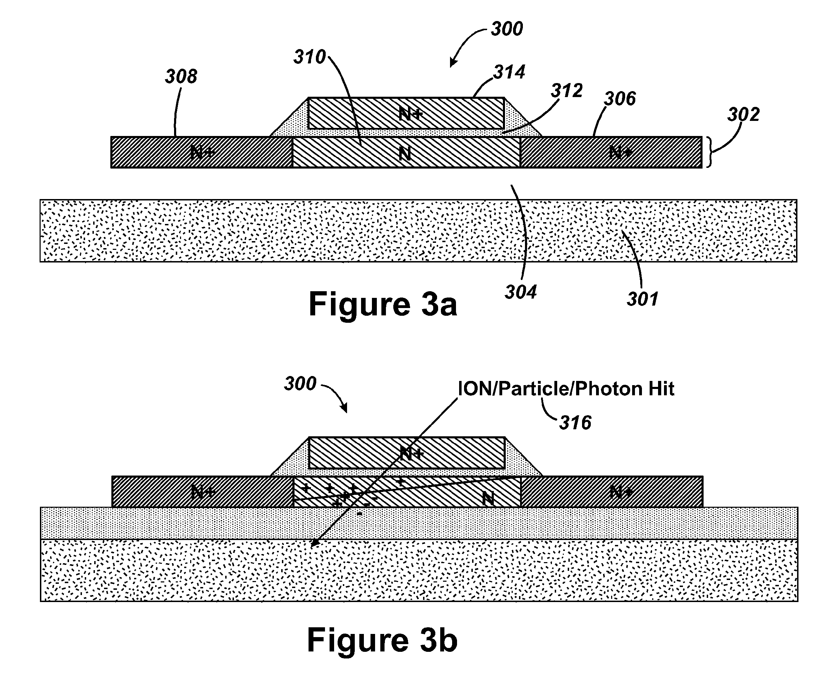

Figure 3a is a diagram showing an n-type majority carrier field effect transistor device 300 fabricated with an SOI CMOS process, according to an embodiment of the present invention. Device 300 may comprise a thin semiconductor layer 302, which is above an insulating layer 304. Thin semiconductor layer 302 may be silicon, polysilicon, amorphous silicon, single crystal silicon, or any other suitable material or semiconductor. Insulating layer 304 may be a buried oxide layer and may advantageously minimize back-gating effects in device 300. A silicon or other semiconductor substrate 301 may be disposed beneath insulating layer 304.

Device 300 may have a source 306 connected to a drain 308 by a channel 310. Channel 310 may be of different dimensions than source 306 and drain 308. Source 306 and drain 308 may share a doping type and may have approximately the same dopant concentration. In Figure 3, source 306 and drain 308 may be of n-type doping, with a dopant concentration represented as N+. Channel 310 may share the doping polarity of source 306 and drain 308. The dopant concentration present in channel 310, however, may be less than that present in source 306 and drain 308. For example, in Figure 3, channel 310 is of n-type doping, but has a dopant concentration ofN, less than N+. The majority carriers of device 300 are electrons, and the minority carriers of device 300 are holes.

Device 300 may further comprise a second insulating layer 312 disposed above channel 310. Second insulating layer 312 may be made of oxide and may be substantially thicker than insulating layer 304. Second insulating layer 312 may run the entire length of channel 310 and may overlap source 306 and drain 308. Above second insulating layer 312 may be disposed a gate 314. Gate 314 may be of the same doping type as source 306 and drain 308, here represented as N+. Gate 314 may be made of a conductor or other appropriate material.

Channel 310 may not be height-matched to source 306 and drain 308. For example, channel 310 may not extend as far up from insulating layer 304 as source 306 and drain 308. In that embodiment, insulating layer 312 would be thicker over channel 310 than shown in Figure 3a to ensure no gap existed between channel 310 and insulating layer 312. A configuration with such a vertically short-vertical as oriented in Figure 3a-channel may be chosen to increase the impedance of the device.

Device 300 may operate similarly to a junction field effect transistor (JFET) or a Metal Schottky gate field effect transistor (MESFET). For example, gate 314 may modulate channel 310. The lower dopant concentration of channel 310, relative to that of source 306 and drain 308, may allow gate 314 to modulate channel 310 without modulating source 306 or drain 308. Unlike that of a JFET or a MESFET, gate 314 of device 300 is insulated, and no p-n junctions are present in device 300.

Figure 3b is a diagram showing the effect of a particle strike on an embodiment of the present invention. Unlike the typical MOSFET device, in which a parasitic bipolar transistor is activated upon a strike as shown in Figure 2, device 300, a majority carrier field effect transistor according to an embodiment of the present invention, acts as a resistor when struck by ion particle 316 (an SEE hit). Because device 300 is a majority carrier device, excess minority carriers generated during an SEE hit will be rapidly recombined with the excess majority carriers generated by the hit or be swept out of the region by electric fields present due to the bias configuration.

Thus, device 300 may be less susceptible to SEE hits than standard CMOS devices. Such lower susceptibility could be represented by a graph like that shown in Figure 1. But the curve for circuits using embodiments of the present invention would be shifted to the right, indicating no disruption of normal operation up to a higher magnitude of LET, for example up to 40 MeV-cm2/mg (Si). Device 300 may have no mechanism for gain of the minority carriers as in the CMOS device.

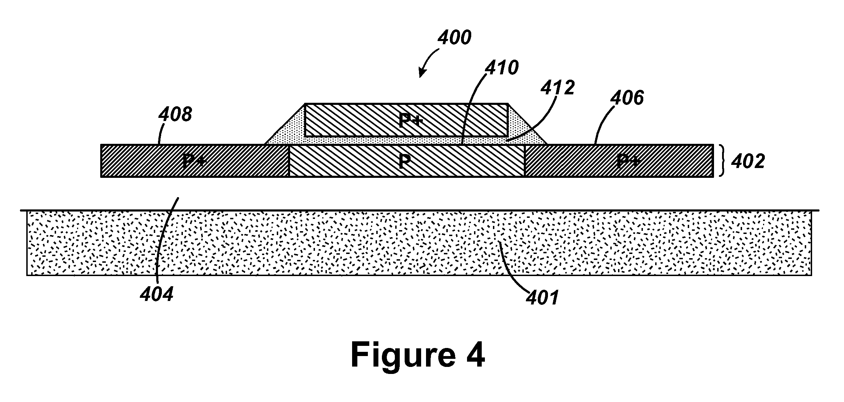

Similar to the n-type transistor device 300 shown in Figure 3, p-type majority carrier field effect transistors are also possible. Figure 4 is a diagram showing a p-type majority carrier field effect transistor 400 fabricated with an SOI CMOS process, according to another embodiment of the present invention. Device 400 may comprise a thin semiconductor layer 402, which is above an insulating layer 404. Thin semiconductor layer 402 may be silicon, polysilicon, amorphous silicon, single crystal silicon, or any other suitable material or semiconductor. Insulating layer 404 may be a buried oxide layer and may advantageously minimize back-gating effects in device 400. A silicon or other semiconductor substrate 401 may be disposed beneath insulating layer 404

Device 400, like device 300, may have a source 406 connected to a drain 408 by a channel 410. Source 406 and drain 408 may share a doping type and may have approximately the same dopant concentration. In Figure 4, source 406 and drain 408 may be of p-type doping, with a dopant concentration represented as P+. Channel 410 may share the doping polarity of source 406 and drain 408. The dopant concentration present in channel 410, however, may be less than that present in source 406 and drain 408. For example, in Figure 4, channel 410 is of p-type doping, but has a dopant concentration of P, less than P+. The majority carriers of device 400 are holes, and the minority carriers of device 400 are electrons.

Device 400 may further comprise a second insulating layer 412 disposed above channel 410. Second insulating layer 412 may be made of oxide and may be substantially thicker than insulating layer 404. Second insulating layer 412 may run the entire length of channel 410 and may overlap source 406 and drain 408. Above second insulating layer 412 may be disposed a gate 414. Gate 414 may be of the same doping type as source 406 and drain 408, here represented as P+. Gate 314 may be made of a conductor or other appropriate material.

Channel 410 may not be height-matched to source 406 and drain 408. For example, channel 410 may not extend as far up from insulating layer 404 as source 406 and drain 408. In that embodiment, insulating layer 412 would be thicker over channel 410 than shown in Figure 4 to ensure no gap existed between channel 410 and insulating layer 412. A configuration with such a vertically short-vertical as oriented in Figure 4-channel may be chosen to increase the impedance of the device.

Device 400 may display a similar hardening to SEEs as device 300. For example, upon a particle strike to channel 410, device 400 may operate like a resistor, rather than as a parasitic bipolar transistor, as may occur with a typical MOSFET device.

Device 300 may have a faster and higher gain than device 400 and a better frequency response than device 400. This may be due to the greater mobility of the majority carriers of device 300, electrons, compared to the majority carriers of device 400, holes. These devices, however, are suitable for use in CMOS architectures, and circuits could be fabricated using both n-type majority carrier field effect transistors, similar to device 300, and p-type majority carrier field effect transistors, similar to device 400, in complementary layouts.

The fabrication of this device may be integrated in an SOI CMOS process. These device may be fabricated in a thin (several thousand angstrom thick) single crystal region over a buried oxide (typically several thousand angstrom thick).

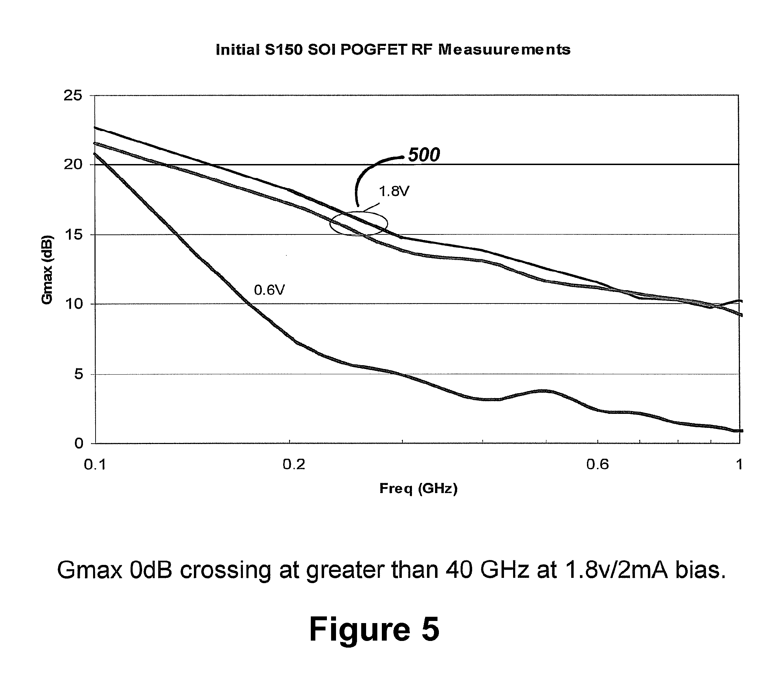

Figure 5 depicts a graph showing the high frequency capabilities of yet another embodiment of the present invention. Using an un-optimized n-type prototype, the maximum available gain (y-axis) was measured at two different bias voltages. A pair of curves 500 in Figure 5 indicate that the gain decreases to 0 dB at a frequency above 40GHz (data point not shown), even at low bias levels of 1.8V/2mA.

It should be understood, however, that this and other arrangements and embodiments described herein are set forth for purposes of example only, and other arrangements and elements (e.g., machines, interfaces, functions, and orders of elements) can be added or used instead and some elements may be omitted altogether. Further, as in most circuits, those skilled in the art will appreciate that many of the elements described herein are functional entities that may be implemented as discrete components or in conjunction with other components, in any suitable combination and location. For example, an exemplary device may be fabricated using different processes or materials to yield similar results, and may be one component in a larger functional arrangement, not shown in the Figures.

## Claims

1. We claim: A field effect transistor comprising:
a source region of a first doping type embedded in a thin semiconductor layer, wherein the first doping type is of opposite polarity to the second doping type;
a drain region of the first doping type embedded in the thin semiconductor layer;
a channel region of the first doping type embedded in the thin semiconductor layer and disposed so that a first end of the channel region contacts the source region and a second end of the channel region contacts the drain region;
an insulating layer disposed above the channel region; and
a gate region disposed above the insulating layer, wherein applying electrical potential to the gate region controls the flow of charge in the channel region.

2. The field effect transistor of claim 1, wherein the channel has a lower dopant concentration than the source and the drain.

3. The field effect transistor of claim 2, wherein the thin semiconductor layer comprises silicon.

4. The field effect transistor of claim 3, wherein the first doping type is n-type doping and the second doping type is p-type doping.

5. The field effect transistor of claim 3, wherein the first doping type of p-type doping and the second doping type is n-type doping.

6. The field effect transistor of claim 1, further comprising a semiconductor substrate and an second insulating layer, wherein the second insulating layer is between the thin semiconductor layer and the semiconductor substrate.

7. The field effect transistor of claim 1, wherein the gate region comprises a conductor.
